# EUROPÄISCHE PATENTSCHRIFT

(11) **EP 1 162 569 B1**
(45) Veröffentlichungstag und Bekanntmachung des Hinweises auf die Patenterteilung: **14.12.2005**
(21) Anmeldenummer: 01120744.6
(22) Anmeldetag: 02.02.1998
(51) Int. Cl.: G06K 19/077

(54) **Verfahren zur Herstellung eines Datenträgers**
Method of producing a data carrier
Méthode de production d'un porteur de données

(30) Priorität: 03.02.1997 DE 19703990
(43) Veröffentlichungstag der Anmeldung: 12.12.2001
(62) Teilanmeldung aus: 98908041.1
(73) Patentinhaber: Giesecke & Devrient GmbH, 81677 München (DE)
(72) Erfinder: Tarantino, Thomas, 83410 Laufen (DE); HaghiriTehrani, Yahya, 80797 München (DE)
(74) Vertreter: Klunker . Schmitt-Nilson . Hirsch

(56) Entgegenhaltungen:
- EP-A- 0 671 705
- DE-A- 4 326 816
- DE-A- 4 340 249

## Beschreibung

Die Erfindung betrifft ein Verfahren zur Herstellung eines kartenförmigen Datenträgers, bestehend aus einem Kartenkörper mit einer Antenne, und einem Chipmodul mit einem integrierten Schaltkreis, der elektrisch leitend mit der Antenne verbunden ist.

Ein derartiger Datenträger kann als Kreditkarte, Bankkarte elektronische Börse usw. ausgebildet sein und zur kontaktlosen Abwicklung von Transaktionen eingesetzt werden, beispielsweise zum Entrichten eines Beförderungsentgelts im Personennahverkehr oder zum Bezahlen eines Kaufpreises für eine Ware oder eine Dienstleistung. Weiterhin kann ein derartiger Datenträger auch als Ausweis für eine berührungslose Zugangskontrolle eingesetzt werden. In diesem Fall ist in dem integrierten Schaltkreis eine Kennung gespeichert, mit deren Hilfe der Zutritt zu einem abgesperrten Bereich in einem Gebäude freigeschaltet werden kann.

Aus der DE 44 16 697 A1 sind bereits eine Reihe von Varianten für Aufbau und Herstellung eines derartigen Datenträgers bekannt. Dort ist unter anderem ein Kartenkörper offenbart, der eine Spule aufweist und eine Aussparung zur Aufnahme eines Chipmoduls. Das Chipmodul wird so in die Aussparung eingesetzt, daß eine elektrisch leitende Verbindung zwischem dem integrierten Schaltkreis des Chipmoduls und der im Kartenkörper enthaltenen Spule hergestellt wird. Einzelheiten zur Herstellung der Aussparung und insbesondere zur Freilegung der Anschlüsse der Spule sind der DE 44 16 697 A1 nicht entnehmbar.

Aus der DE 43 26 816 (vergl. den Oberbegriff von Anspruch 1) ist weiterhin ein Verfahren zur Herstellung eines kartenförmigen Datenträgers entnehmbar, bei dem ein Kartenkörper bereitgestellt wird, auf dessen einer Oberfläche ein integrierter Schaltkreis angeordnet wird, und auf dessen anderer Oberfläche Kontakte ausgebildet sind. Um den integrierten Schaltkreis elektrisch mit den Kontakten zu verbinden, werden in dem Kartenkörper Aussparungen angelegt, indem das Kartenmaterial über den Kontakten im Bereich der vorgesehenen Anschlüsse abgetragen wird. Bei dem Materialabtrag wird auch ein Teil der Kontakte abgetragen, um zu gewährleisten, daß die Anschlußbereiche nicht korodiert sind. Dieses bekannte Herstellungsverfahren erfordert eine sehr präzise Führung des für den Materialabtrag eingesetzten Fräs- oder Bohrwerkzeuges, da die Kontakte keinesfalls gänzlich durchbrochen werden dürfen, andererseits zur Erreichung des angestrebten Zieles, eine nicht korodierte Oberfläche zu schaffen, ein Mindestabtrag erzielt werden muß. Das Verfahren ist deshalb in der Regel nur einsetzbar, wenn die geometrischen Verhältnisse bei dem bearbeiteten Kartenkörper vollständig bekannt sind.

Aus der DE 43 40 249 A1 ist weiterhin ein zweistufiges Bohrstoppverfahren zum Einbringen von Sacklöchern in mehrschichtige Leiterplatten bekannt, welche eine leitende Oberfläche sowie mindestens eine im Inneren liegende Leiterschicht aufweisen. Das Einsenken des Bohrwerkzeuges wird dabei gesteuert, indem bei Berührung der leitenden Oberflächenschicht ein erstes Signal zur Definition einer Null-Lage und bei Berührung der innenliegenden Leiterschichten jeweils weitere Signale zur Bestimmung der jeweils erreichten Leiterschicht und damit zur Bestimmung eines Bohrstopps genommen werden. Das Verfahren setzt voraus, daß die Oberflächenschicht sowie die innenliegende Leiterschicht durch mechanischen Kontakt mit einem Meßsignal beaufschlagt werden können.

Für kartenartige flache Substrate mit Leiterstrukturen, die von außen mechanisch kontaktierbar sind, ist es also bekannt, Aussparungen einzubringen, durch die unter einer Oberfläche, von der aus der Materialabtrag erfolgt, liegende Leiterstrukturen zuverlässig freigelegt werden.

Der Erfindung liegt die Aufgabe zugrunde, ein Verfahren zur zuverlässigen Freilegung von in einem kartenförmigen Datenträger eingebetteten Leiterstrukturen anzugeben, wenn die Leiterstrukturen mechanisch von außen nicht zugänglich sind.

Diese Aufgabe wird gelöst durch ein Verfahren mit den Merkmalen des Anspruchs 1.

Der Grundgedanke der Erfindung besteht darin, zur Steuerung des Materialabtrages zur Freilegung der Anschlüsse einer Antenne ein elektrisches Signal zu nutzen, das mittels eines elektromagnetischen Signales auf die Antenne gegeben und mittels eines in dem zum Materialabtrag eingesetzten Werkzeug angeordneten Sensors erfaßt wird.

Erfindungsgemäß wird mittels des Sensorsignals festgestellt, wann der Materialabtrag an den Anschlüssen der Antenne beginnt. Dieses Sensorsignal wird dazu verwendet, den Vortrieb des materialabtragenden Werkzeuges zu stoppen. Das Werkzeug läßt sich auf diese Art und Weise sehr genau steuern, und zwar unabhängig von einer eventuellen fertigungsbedingten Streuung der Position der Anschlüsse der Antenne in dem Kartenkörper.

Diese Vorgehensweise hat den Vorteil, daß ggf. auf den Anschlüssen vorhandene Schmutz- oder Oxidschichten durch den Materialabtrag entfernt werden und somit optimale Voraussetzungen für eine zuverlässige elektrische Verbindung zwischen den Anschlüssen der Antenne und dem integrierten Schaltkreis des Chipmoduls geschaffen werden.

Ein weiterer Vorteil der Erfindung ist darin zu sehen, daß bei der Freilegung der Anschlüsse der Antenne ein größerer Toleranzbereich zulässig ist, wenn man einen Materialabtrag an den Anschlüssen einkalkuliert, verglichen mit dem Fall, daß man die Oberfläche der Anschlüsse exakt freilegt. Wenn die Anschlüsse der Antenne sehr genau im Kartenkörper lokalisiert sind, ist im Rahmen des erfindungsgemäßen Verfahrens bei der Freilegung der Anschlüsse der Antenne eine Toleranz in der Größenordnung der halben Dicke der Anschlüsse ohne weiteres zulässig.

In einer bevorzugten Ausführungsform erfolgt der für die Freilegung der Anschlüsse der Antenne erforderliche Materialabtrag so, daß die Anschlüsse schräg angeschnitten werden. Auf diese Art und Weise kann der zulässige Toleranzbereich noch erheblich vergrößert werden, da bei einem schrägen Anschnitt der Anschlüsse über einen relativ großen Vortriebsbereich des materialabtragenden Werkzeugs noch ausreichend Material für die Kontaktierung des integrierten Schaltkreises des Chipmoduls stehen bleibt. Es verschiebt sich dabei allenfalls der laterale Ort der Kontaktierung, was aber keine größeren Probleme bereitet. Ein weiterer Vorteil des schrägen Anschnitts besteht darin, daß eine größere Anschlußfläche für die Kontaktierung zur Verfügung steht und somit ein zuverlässiger Kontakt hergestellt werden kann.

Vorteilhafte und zweckmäßige Ausgestaltungen und Weiterbildungen der Erfindung sind nachfolgend dargestellt.

Es zeigen:
- Fig. 1: einen mit einer Antenne versehenen Datenträger in Aufsicht,
- Fig. 2: eine Schnittdarstellung des in Fig. 1 dargestellten Datenträgers,
- Fig. 3 bis 5: jeweils einen vergrößerten Ausschnitt eines Datenträgers in Schnittdarstellung zur Veranschaulichung wichtiger Schritte des Herstellungsverfahrens,
- Fig. 6, 7, 8: vergrößerte Ausschnitte verschiedener Beispiele eines Datenträgers nach dem Einsetzen des Chipmoduls in Schnittdarstellung,
- Fig. 9 bis 12: vergrößerte Ausschnitte verschiedener Ausführungsbeispiele eines Datenträgers nach dem Freilegen der Antennenanschlüsse in Schnittdarstellung und
- Fig. 13: eine sensorgesteuerte Anordnung zum präzisen Freilegen der Antennenanschlüsse.

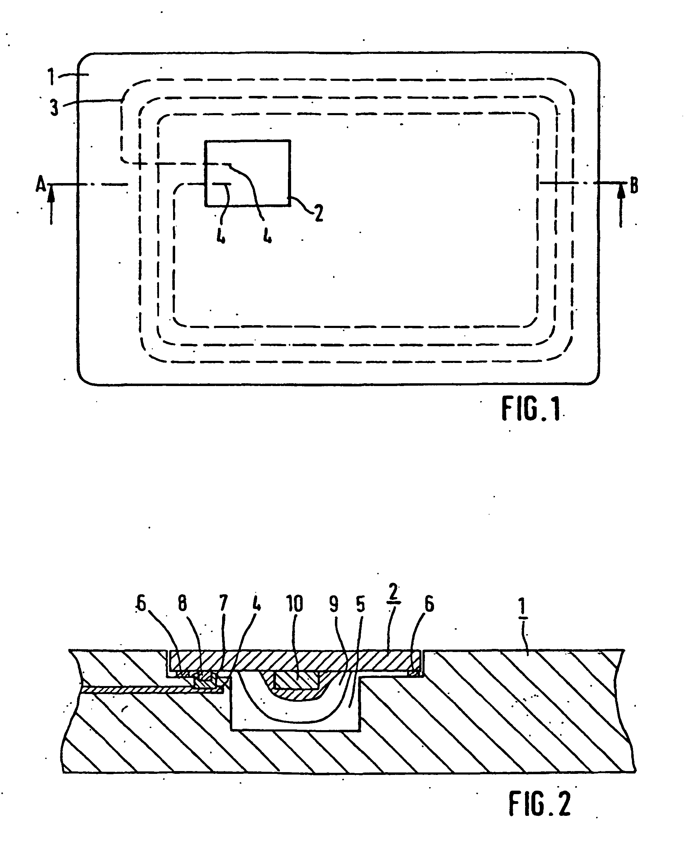

Fig. 1 zeigt einen mit einer Antenne versehenen Datenträger in Aufsicht. Bei dem Datenträger handelt es sich um eine Chipkarte gemäß der ISO-Norm. Der Kartenkörper 1 dieser Chipkarte enthält ein Spulenelement 3, das als Sende- und Empfangsantenne für einen figürlich nicht dargestellten, integrierten Schaltkreis eines Chipmoduls 2 dient. Das Spulenelement 3 ist bei dem in Fig. 1 dargestellten Ausführungsbeispiel vollständig in den Kartenkörper eingebettet und daher von außen nicht sichtbar. Zur Veranschaulichung der Lage des Spulenelements 3 im Kartenkörper ist das Spulenelement 3 in Fig. 1 schematisch durch eine gestrichelte Linie dargestellt. Das Chipmodul 2 ist in eine Aussparung des Kartenkörpers 1 eingesetzt und über die Anschlüsse 4 mit dem Spulenelement 3 verbunden. Statt des Spulenelements 3 kann als Antenne auch eine kapazitive Koppelfläche oder ein anderes Übertragungsglied vorgesehen werden.

Fig. 2 zeigt die in Fig. 1 dargestellte Chipkarte in einer Schnittdarstellung. Der Schnitt wurde entlang der in Fig. 1 eingezeichneten Linie A-B gelegt. Zur besseren Veranschaulichung der Details der Erfindung ist in Fig. 2 nicht die ganze Chipkarte dargestellt, sondern lediglich ein vergrößerter Ausschnitt der Chipkarte. Das Chipmodul 2 ist so in eine zweistufige Aussparung 5 des Kartenkörpers 1 eingepaßt, daß die Oberfläche des Chipmoduls 2 mit der Oberfläche des Kartenkörpers 1 fluchtet und die Kontakte 8 des Chipmoduls 2 gegenüber den freigelegten und teilweise abgetragenen Anschlüssen 4 des Spulenelements 3 zu liegen kommen. Hierzu ist die Aussparung 5 so dimensioniert, daß sie das Chipmodul 2 samt einer Vergußmasse 9, die einen integrierten Schaltkreis 10 umgibt, aufnehmen kann. Die mechanische Verbindung zwischen dem Chipmodul 2 und dem Kartenkörper 1 kann beispielsweise mit Hilfe eines thermoaktivierbaren Klebers 6 hergestellt werden. Die elektrische Verbindung zwischen dem Chipmodul 2 und dem im Kartenkörper 1 enthaltenen Spulenelement 3 kann mittels eines leitfähigen Klebers 7 erfolgen, der auf die Anschlüsse 4 des Spulenelements 3 oder auf die Kontakte 8 des Chipmoduls 2 aufgebracht ist. Der leitfähige Kleber 7 kann gleichzeitig auch die Aufgabe der mechanischen Verbindung zwischen Chipmodul 2 und Kartenkörper 1 übernehmen, so daß in diesem Fall der thermoaktivierbare Kleber 6 entfallen kann.

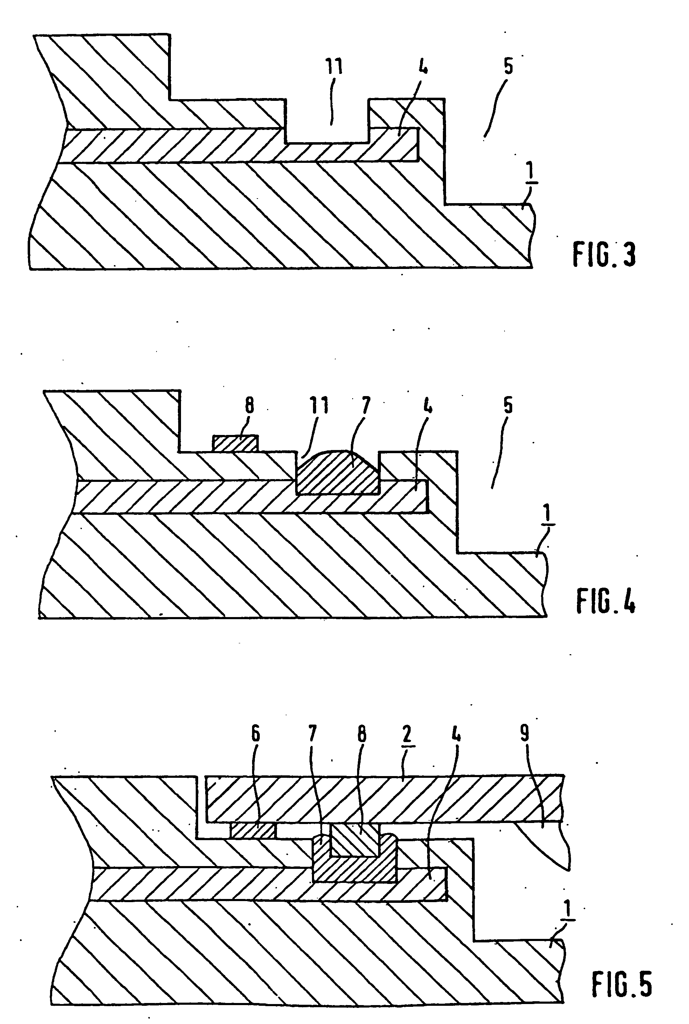

Wichtige Verfahrensschritte des Herstellungsverfahrens sind in den Fig. 3,4 und 5 dargestellt. Diese Figuren zeigen jeweils einen vergrößerten Ausschnitt der Chipkarte in Schnittdarstellung. Der Ausschnitt erstreckt sich jeweils über die nähere Umgebung einer der Anschlüsse 4.

In Fig. 3 ist die Chipkarte nach Herstellung der zweistufigen Aussparung 5 und Freilegen des Anschlusses 4 des Spulenelements 3 dargestellt. Der Anschluß 4 des Spulenelements 3 wurde durch Einbringen einer Vertiefung 11 in die zweistufige Aussparung 5 freigelegt. Die Vertiefung 11 erstreckt sich in den Anschluß 4 des Spulenelements 3 hinein, d.h. es wurde nicht nur Kartenmaterial abgetragen, sondern auch am Anschluß 4 des Spulenelements 3 fand ein Materialabtrag statt. Sowohl die zweistufige Aussparung 5 als auch die Vertiefung 11 können mittels geeigneter Fräswerkzeuge hergestellt werden. Je nach spezieller Ausgestaltung der Vertiefung 11 kann zu deren Herstellung auch ein kombiniertes Fräswerkzeug bzw. ein einziges Fräswerkzeug verwendet werden.

In Fig. 4 ist dargestellt, wie die gemäß Fig. 3 präparierte Chipkarte mit dem leitfähigen Kleber 7 und dem thermoaktivierbaren Kleber 8 versehen wird. Dies kann entweder in einem einzigen Verfahrensschritt oder auch in getrennten Verfahrensschritten geschehen. Für den leitfähigen Kleber 7 kann beispielsweise ein Flüssigkleber verwendet werden. Der leitfähige Kleber 7 wird in die Vertiefung 11 eingefüllt. Die genaue Dosiermenge hängt von der Geometrie der Vertiefung 11 und auch von der Geometrie des Kontaktes 8 am Chipmodul 2 ab. So wird die Vertiefung 11 in der Regel nur teilweise mit dem leitfähigen Kleber 7 aufgefüllt, wenn der Kontakt 8 des Chipmoduls 2 in die Vertiefung 11 hineinragt. Liegt der Kontakt 8 des Chipmoduls 2 dagegen nur auf den Rändern der Vertiefung 11 auf bzw. ist der Kontakt 8 vertieft im Chipmodul 2 eingebracht, ohne daß er in die Vertiefung 11 hineinragt, so ist es erforderlich, entsprechend mehr von dem leitfähigen Kleber 7 zu dosieren, so daß dieser über den Rand der Vertiefung hinausragt. Dabei kann es unter Umständen günstig sein, Ausgleichshohlräume vorzusehen, die den beim Einsetzen des Chipmoduls verdrängten überschüssigen leitfähigen Kleber 7 aufnehmen können. Alternativ ist es auch möglich, einen leitfähigen Kleber 7 einzusetzen, der als thermoaktivierbare Klebefolie ausgeführt ist. Insbesondere kann diese Klebefolie so aufgebaut sein, daß sie in Richtungen senkrecht zu ihrer Oberfläche durchgehend leitfähig ist und in Richtungen parallel zu ihrer Oberfläche nur lokal leitfähig ist. Derartige Spezialfolien bieten sich insbesondere dann an, wenn sowohl die elektrische als auch die mechanische Verbindung zwischen Chipmodul 2 und Kartenkörper 1 mit ein und derselben Klebefolie hergestellt werden soll. Die gerichtete Leitfähigkeit der Klebefolie ermöglicht es dann, ein durchgehendes Folienstück zu verwenden, ohne daß dabei die Anschlüsse 4 der Antenne 3 kurzgeschlossen werden.

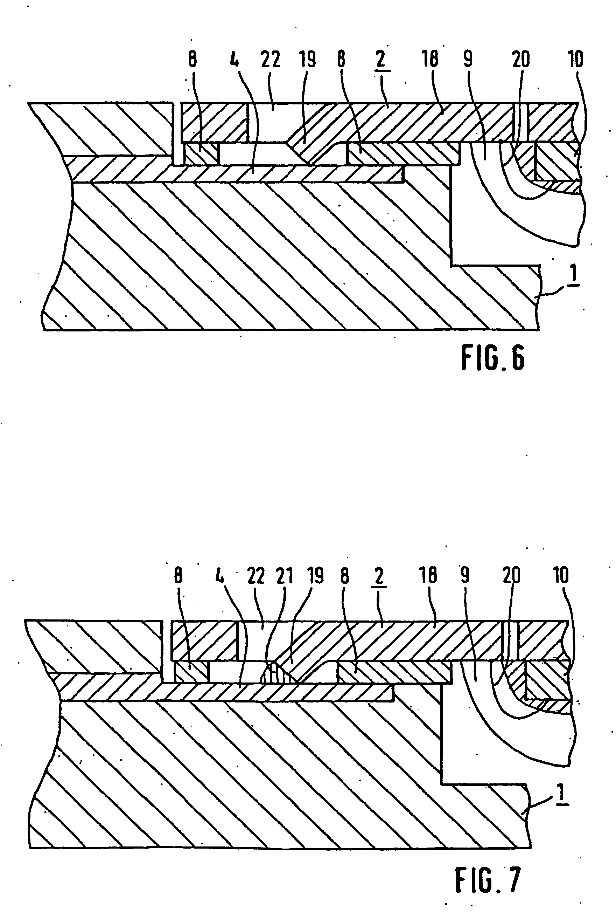

Der thermoaktivierbare Kleber 8 kann beispielsweise in Form einer entsprechend geformten Folie in die zweistufige Aussparung eingebracht werden. Es wäre hier auch denkbar, einen flüssigen Kleber zu verwenden oder auch mikroverkapselte Klebstoffe, die durch Zerstörung der Mikrokapseln aktiviert werden. Der thermoaktivierbare Kleber 8 kann sowohl - wie dies in Fig. 4 gezeigt ist - auf dem Kartenkörper 1 angebracht werden, als auch an einer entsprechenden Stelle des Chipmoduls 2. Nach dem Aufbringen des leitfähigen Klebers 7 und des thermoaktivierbaren Klebers 8 wird das Chipmodul 2 in die zweistufige Aussparung 5 eingefügt, wie dies in Fig. 5 gezeigt ist.

In Fig. 5 ist die Chipkarte zusammen mit dem eingepaßten Chipmodul 2 dargestellt. Die elektrische Verbindung zwischen dem Chipmodul 2 und dem Spulenelement 3 entsteht dadurch, daß der Kontakt 8 des Chipmoduls 2 in den leitfähigen Kleber 7 eintaucht, der zuvor in die Vertiefung 11 eingebracht wurde. Der Boden der Vertiefung 11 und auch ein Teil der Wandung wird vom Anschluß 4 des Spulenelements 3 gebildet, so daß auf diese Weise die elektrische Verbindung zum Spulenelement 3 hergestellt wird. Zur Herstellung bzw. Verstärkung der mechanischen Fixierung des Chipmoduls 2 am Kartenkörper 1 dient der thermoaktivierbare Kleber 6. Der Verbund zwischen dem Kartenkörper 1 und dem Chipmodul 2 mittels des thermoaktivierbaren Klebers 6 kann dadurch hergestellt werden, daß das Chipmodul 2 unter Anwendung von Druck und Hitze in die zweistufige Aussparung 5 des Kartenkörpers 1 eingefügt wird. Der thermoaktivierbare Kleber 6 wird dadurch aktiviert und verbindet sich mit dem Chipmodul 2 und dem Kartenkörper 1 zu einer dauerhaften Klebeverbindung. Ebenso ist es auch denkbar, für den leitfähigen Kleber 7 ein Material zu wählen, das thermisch aktiviert werden kann, so daß im gleichen Verfahrensschritt sowohl die elektrische Verbindung mittels des leitfähigen Klebers 7 als auch die mechanische Verbindung mittels des thermoaktivierbaren Klebers 6 hergestellt werden kann.

Der thermoaktivierbare Kleber 6 kann auch ganz entfallen, wenn allein durch den leitfähigen Kleber 7 ein Klebeverbund mit ausreichend hoher mechanischer Festigkeit hergestellt werden kann. In einer Variante ist es auch möglich, nur den thermoaktivierbaren Kleber 6 vorzusehen und den leitfähigen Kleber 7 wegzulassen. Hierzu ist die Geometrie des Kontaktes 8 und der Vertiefung 11 so aufeinander abzustimmen, daß es beim Einfügen des Chipmoduls 2 in die zweistufige Aussparung 5 und dem damit einhergehenden Verkleben mittels des thermoaktivierbaren Klebers 6 zu einer dauerhaften elektrischen Verbindung zwischen dem Kontakt 8 des Chipmoduls 2 und dem Anschluß 4 des Spulenelements 3 kommt. Die Ausbildung der elektrischen Verbindung zwischen dem Kontakt 8 des Chipmoduls 2 und dem Anschluß 4 des Spulenelements 3 kann durch weitere Maßnahmen unterstützt werden, wie beispielsweise mechanische Verformung, Schweißen, Löten, Bonden usw.

Die Ausbildung der elektrischen Verbindung zwischen dem Kontakt 8 des Chipmoduls 2 und dem Anschluß 4 des Spulenelements 3 kann auch ohne den leitfähigen Kleber 7 durch mechanische Berührung des Kontaktes 6 und des Anschlusses 4 erfolgen. Ein Ausführungsbeispiel für eine berührende Kontaktierung ist in Fig. 6 dargstellt. Besonders gut eignet sich die berührende Kontaktierung bei Verwendung eines Leadframe-Moduls, d.h. eines Chipmoduls 2, das aus einem in einer Vergußmasse 9 angeordneten integrierten Schaltkreis 10 und einem Leiternetz 18 besteht. Das Leiternetz 18 wird in der Regel durch Ausstanzen aus einer Metallfolie hergestellt, wobei die Gestaltung des Leiternetzes 18 davon abhängt, ob das Chipmodul 2 im späteren Betrieb kontaktlos über das im Kartenkörper 1 enthaltene Spulenelement 3 mit der Außenwelt kommunizieren soll oder kontaktbehaftet über als Kontaktflächen ausgebildete Bereiche des Leiternetzes 18. In allen Fällen werden zur Herstellung der elektrischen Verbindung zwischen dem Chipmodul 2 und dem Spulenelement 3 durch stellenweises Prägen des Leiternetzes 18 über die Hauptfläche des Leiternetzes 18 überstehende Bereiche 19 und Öffnungen 22 erzeugt, wobei die überstehenden Bereiche 19 nach Einsetzen des Chipmoduls 2 in den Kartenkörper 1 in mechanischen und damit auch elektrischen Kontakt mit dem Anschluß 4 des Spulenelements 3 treten. Dabei kann das Ausmaß der Prägung so eingestellt werden, daß bedingt durch die Federwirkung der überstehenden Bereiche 19 ein vorgebbarer Druck auf den Anschluß 4 des Spulenelements 3 ausgeübt wird, so daß es auch bei einer mechanischen Beanspruchung, wie z.B. beim Biegen der Chipkarte zu einer sicheren elektrischen Kontaktierung zwischen Spulenelement 3 und integriertem Schaltkreis 10 kommt.

Im Falle eines Chipmoduls 2, das auch für einen kontaktbehafteten Betrieb vorgesehen ist, können die überstehenden Bereiche 19 Bestandteil der für die Kommunikation mit der Außenwelt vorgesehenen Kontaktflächen sein. Diese Kontaktflächen bzw. die überstehenden Bereiche 19 des Leiternetzes 18 können beispielsweise über Bonddrähtchen 20 elektrisch leitend mit dem integrierten Schaltkreis 10 verbunden sein.

Zur Herstellung einer mechanischen Verbindung zwischen dem Chipmodul 2 und dem Kartenkörper 1 kann analog zu den anderen Ausführungsbeispielen ein thermoaktivierbarer Kleber 8 vorgesehen sein, der beispielsweise in Form einer entsprechend geformten Folie am Chipmodul 2 oder in der zweistufigen Aussparung des Kartenkörpers 1 angebracht ist. Das Einbringen des Chipmoduls 2 in den Kartenkörper 1 entspricht im übrigen der Vorgehensweise der vorstehend beschriebenen Ausführungsbeispiele.

Ein weiteres Ausführungsbeispiel ist in Fig. 7 dargestellt. Bei diesem Ausführungsbeispiel wird das bereits in der Fig. 6 beschriebene Leadframe-Modul verwendet. Im Falle der Fig. 7 wird der elektrische Kontakt zwischen den überstehenden Bereichen 19 des Leiternetzes 18 und dem Anschluß 4 des Spulenelements 3 jedoch nicht oder nicht alleine durch mechanische Berührung hergestellt, sondern durch eine Schweißverbindung 21. Diese Schweißverbindung 21 kann beispielsweise mittels eines Laserstrahls hergestellt werden, der durch die beim Abprägen der Bereiche 19 entstehenden Öffnungen 22 im Leiternetz 18 eingestrahlt wird.

Sowohl beim Ausführungsbeispiel gemäß Fig. 6 als auch beim Ausführungsbeispiel gemäß Fig. 7 kann das Abprägen der Bereiche 19 des Leiternetzes 18 auch erst beim Einsetzen des Chipmoduls 2 in den Kartenkörper 1 erfolgen. Dadurch können die Klebeverbindung zwischen Chipmodul 2 und Kartenkörper 1 und die Abprägung des Leiternetzes 18 in einem Arbeitsschritt hergestellt werden.

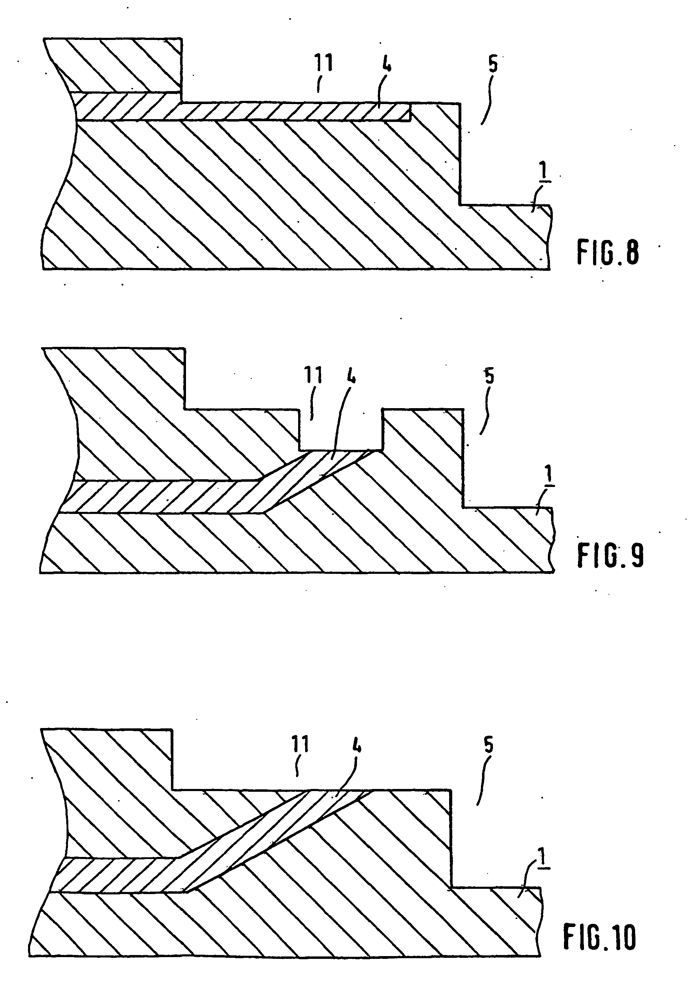

In den Fig. 8 bis 12 sind weitere Ausführungsbeispiele für die Anordnung der Anschlüsse 4 des Spulenelements 3 im Kartenkörper 1 bzw. für das Freilegen der Anschlüsse 4 dargestellt. Wie in den Fig. 3 bis 5 ist auch hier jeweils ein vergrößerter Ausschnitt des Kartenkörpers 1 in Schnittdarstellung gezeigt.

Fig. 8 zeigt eine Variante, bei der sich die Vertiefung 11 über die gesamte Fläche der ersten Stufe der zweistufigen Aussparung 5 erstreckt. Mit anderen Worten, der Anschluß 4 des Spulenelements 3 wird mit dem Erzeugen der zweistufigen Aussparung 5 freigelegt und teilweise abgetragen. Bei dieser Variante entfällt somit der zusätzliche Arbeitsschritt für die Herstellung der Vertiefung 11.

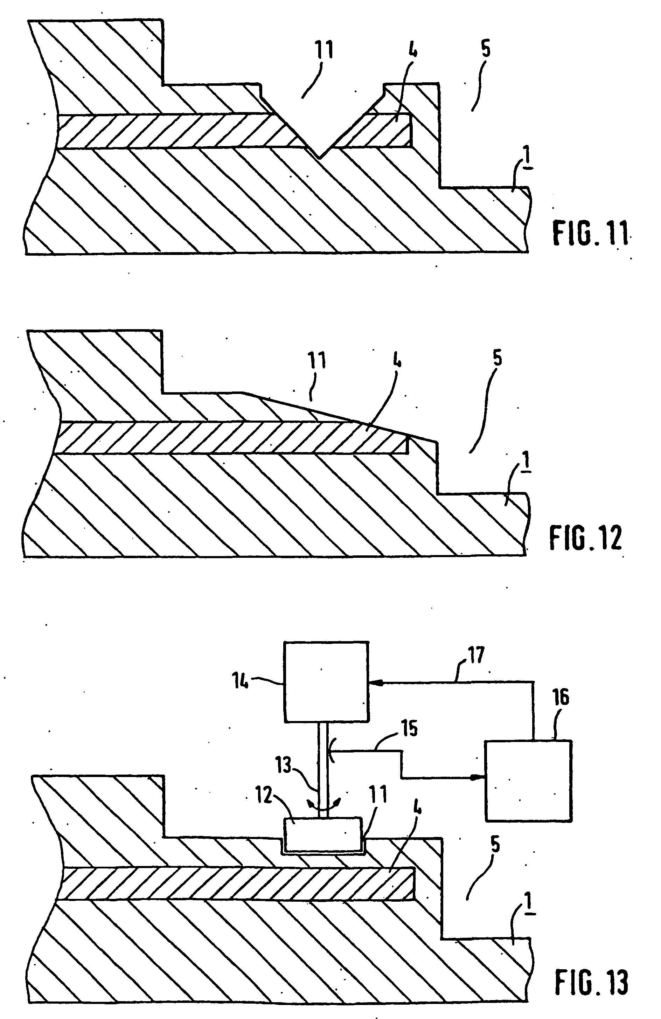

Das in Fig. 9 dargestellte Ausführungsbeispiel entspricht im Hinblick auf die Vertiefung 11 der in den Fig. 3, 4 und 5 dargestellten Ausführungsform. Ein Unterschied besteht jedoch bei der geometrischen Anordnung des Anschlusses 4 des Spulenelements 3. Anders als beim Ausführungsbeispiel gemäß den Fig. 3, 4 und 5 verläuft bei dem in Fig. 13 dargestellten Ausführungsbeispiel der Anschluß 4 nicht parallel zur Kartenoberfläche, sondern schräg in einem vorgebbaren Winkel. Diese Maßnahme hat zur Folge, daß die Tiefe der Vertiefung 11 in relativ großen Grenzen variiert werden kann und trotzdem noch sichergestellt ist, daß der Anschluß 4 zumindest eine Teilfläche des Bodens der Vertiefung 11 bildet und somit eine Kontaktierung des Anschlusses 4 möglich ist. Durch diese Maßnahme ist es je nach dem genauen Wert für den Winkel, den der Anschluß 4 mit der Oberfläche des Kartenkörpers 1 bildet, möglich, für die Tiefe der Vertiefung 11 einen Toleranzbereich zuzulassen, der deutlich größer als die Dicke des Anschlusses 4 sein kann. Desweiteren ist es auch möglich, den zulässigen Toleranzbereich bei der Vertiefung 11 nicht völlig auszuschöpfen und stattdessen eine gewisse Toleranz bei der genauen Lage des Anschlusses 4 relativ zur Kartenoberfläche zuzulassen und somit die Herstellung des Kartenkörpers 1 zu erleichtern.

Auch in Fig. 10 ist eine Ausführungsform mit schräg verlaufendem Anschluß 4 dargestellt. Die Geometrie und Herstellungsart der Vertiefung 11 entspricht dem Ausführungsbeispiel gemäß Fig. 12, d.h. die Vertiefung 11 erstreckt sich über den gesamten Bereich der ersten Stufe der zweistufigen Aussparung 5.

Wie dies in Fig. 11 im einzelnen dargestellt ist, lassen sich die durch den schräg verlaufenden Anschluß 4 hervorgerufenen Effekte in ähnlicher Weise auch durch einen entsprechenden Materialabtrag erzielen. Der Anschluß 4 verläuft bei diesem Ausführungsbeispiel in etwa parallel zur Oberfläche des Kartenkörpers 1. Der Materialabtrag erfolgt so, daß der Anschluß 4 in einem vorgebbaren Winkel schräg angeschnitten wird. Dies kann beispielsweise dadurch erreicht werden, daß ein spitz zulaufendes Fräswerkzeug verwendet wird und somit eine kegelförmige Vertiefung 11 hergestellt wird. Selbst wenn die Vertiefung 11 an ihrem Boden teilweise über den Anschluß 4 hinausragt, so bildet der Anschluß 4 immer noch einen Teilbereich der Wandung der Vertiefung 11, so daß eine elektrische Kontaktierung des Spulenelements 3 sichergestellt ist.

Fig. 12 zeigt ein weiteres Ausführungsbeispiel für einen schräg angeschnittenen Anschluß 4. Die Geometrie gemäß Fig. 12 kann beispielsweise dadurch erreicht werden, daß ein Fräswerkzeug in einer Vortriebsrichtung eingesetzt wird, die nicht senkrecht zur Oberfläche des Kartenkörpers 1 verläuft.

In Fig. 13 ist eine Schnittdarstellung einer Anordnung gezeigt, die ein sehr präzises Freilegen der Anschlüsse 4 des Spulenelements 3 ermöglicht. Das Freilegen erfolgt mit Hilfe eines Fräswerkzeugs 12, das über eine Welle 13 von einem Antrieb 14 in Rotation versetzt wird und in Richtung der Welle 13 lateral verschoben werden kann. Das Fräswerkzeug 12 und die Welle 13 sind aus elektrisch leitfähigem Material hergestellt und untereinander elektrisch leitend verbunden. Die Welle 13 ist mit einem Abgriff 15 versehen, der elektrische Signale an der Welle abgreifen kann und diese zu einer Auswerteelektronik 16 weiterleitet. Die Auswerteelektronik 16 steuert über eine oder mehrere Leitungen 17 den Antrieb 14. Die Auswerteelektronik 16 ist so aufgebaut, daß sie das Spulenelement 3 und damit die Anschlüsse 4 mit einem Signal beaufschlagen kann. Dies geschieht mit Hilfe eines elektromagnetischen Feldes. Solange sich zwischen dem Fräswerkzeug 12 und dem Anschluß 4 des Spulenelements 3 noch Kartenmaterial befindet, das in der Regel einen elektrischen Isolator darstellt, und somit noch kein elektrischer Kontakt zwischen dem Fräswerkzeug 12 und dem Anschluß 4 besteht, kann das Signal nicht bzw. nur in gedämpfter oder modifizierter Form mittels des Abgriffs 15 an der Welle 13 abgegriffen werden. Sobald das Fräswerkzeug 12 den Anschluß 4 freigelegt hat und diesen berührt, ändert sich das an der Welle 13 abgegriffene Signal. Diese Änderung wird von der Auswerteelektronik 16 erkannt und kann zur Steuerung des Antriebs 14 verwendet werden. So kann beispielsweise ab Signaländerung noch ein vorgebbarer Vortrieb gefahren werden, um die obersten Schichten des Anschlusses 4 abzutragen.

Mit der in Fig. 13 dargestellten Anordnung können herstellungsbedingte Streuungen der Lage der Anschlüsse 4 des Spulenelements 3 sehr präzise ausgeglichen werden, da die Lage jeweils meßtechnisch erfaßt wird. Weiterhin macht die Anordnung eine genaue Positionierung des Fräswerkzeugs 12 relativ zur Kartenoberfläche überflüssig, da die Positionierung bei der Vortriebssteuerung nicht kritisch ist, weil der Vortrieb ja anhand des von der Welle 13 abgegriffenen Signals gesteuert wird.

Das erfindungsgemäße Verfahren und der damit mögliche Kartenaufbau können auch bei einer sogenannten Kombikarte eingesetzt werden, die sowohl über eine kontaktierende Kopplung als auch über eine kontaktlose Kopplung mit einem externen Gerät in Datenaustausch treten kann. In diesem Fall weist das Chipmodul 2 entsprechende Kontaktflächen für die kontaktierende Kopplung auf.

In einer Variante der Erfindung wird auf den Einsatz des Chipmoduls 2 als Träger.für den integrierten Schaltkreis 10 verzichtet. Stattdessen wird der integrierte Schaltkreis 10 direkt in eine entsprechend geformte Aussparung des Kartenkörpers 1 eingesetzt. Für die elektrische Verbindung mit den Anschlüssen 4 des Spulenelements 3 sind am integrierten Schaltkreis 10 entsprechende Kontakte vorgesehen.

## Patentansprüche

1. Verfahren zur Herstellung eines kartenförmigen Datenträgers, wobei
- ein einen integrierten Schaltkreis (10) aufweisendes Chipmodul (2) sowie
- ein mit einer Antenne (3) versehener Kartenkörper (1) bereitgestellt wird, dessen Anschlüsse (4) in dem Kartenkörper (1) eingebettet ausgebildet sind, und
- an dem Kartenkörper (1) ein Materialabtrag vorgenommen wird, um die in dem Kartenkörper (1) eingebetteten Anschlüsse (4) freizulegen
**dadurch gekennzeichnet, daß**
- die Antenne (3) vollständig in den Kartenkörper (1) eingebettet wird,
- die Antenne (3) mittels eines elektromagnetischen Feldes mit einem Signal beaufschlagt wird,
- das für den Materialabtrag eingesetzte Werkzeug mit einem Abgriff (15) für ein elektrisches Signal versehen wird,
- und die Ausführung des Materialabtrages gestoppt wird, wenn durch den Kontakt zwischen dem für den Materialabtrag eingesetzten Werkzeug und den Anschlüssen (4) eine Änderung des abgegriffenen elektrischen Signals erzeugt wird.

2. Verfahren nach Anspruch 1, **dadurch gekennzeichnet, daß** der Materialabtrag bei den Anschlüssen (4) derart vorgenommen wird, daß ein schräger Anschnitt entsteht.

3. Verfahren nach Anspruch 2, **dadurch gekennzeichnet, daß** der Winkel, unter dem die Anschlüsse (4) angeschnitten werden, durch die Vorschubrichtung und die Form des materialabtragenden Werkzeugs (12) vorgegeben wird.

4. Verfahren nach Anspruch 2, **dadurch gekennzeichnet, daß** der Winkel, unter dem die Anschlüsse (4) angeschnitten werden, durch die Anordnung der Anschlüsse (4) im Kartenkörper (1) vorgegeben wird, und daß die Anschlüsse (4) schräg zur Oberfläche des Kartenkörpers (1) verlaufen.

5. Verfahren nach Anspruch 1, **dadurch gekennzeichnet, daß** sich das Sensorsignal ändert, sobald das materialabtragende Werkzeug (12) die Anschlüsse (4) berührt.

6. Verfahren nach Anspruch 1, **dadurch gekennzeichnet, daß** das materialabtragende Werkzeug (12) nach Berühren der Anschlüsse (4) noch um einen vorgebbaren Wert weitergefahren wird.

7. Verfahren nach einem der vorhergehenden Ansprüche, **dadurch gekennzeichnet, daß** der Materialabtrag mit Hilfe eines Fräswerkzeugs (12) vorgenommen wird.

8. Verfahren nach einem der vorhergehenden Ansprüche, **dadurch gekennzeichnet, daß** die freigelegten Anschlüsse (4) mittels eines leitfähigen Klebers (7) mit dem Chipmodul (2) verbunden werden.

9. Verfahren nach einem der vorhergehenden Ansprüche, **dadurch gekennzeichnet, daß** die freigelegten Anschlüsse (4) durch mechanische Berührung elektrisch leitender Bereiche (19) des Chipmoduls (2) mit dem Chipmodul (2) verbunden werden.

10. Verfahren nach einem der vorhergehenden Ansprüche, **dadurch gekennzeichnet, daß** die freigelegten Anschlüsse (4) durch Verschweißen mit dem Chipmodul (2) verbunden werden.

## Claims

1. A method for producing a card-shaped data carrier whereby
- a chip module (2) having an integrated circuit (10), and
- a card body (1) provided with an antenna (3) whose terminals (4) are formed to be embedded in the card body (1) are supplied, and
- a material removal is effected on the card body (1) to expose the terminals (4) embedded in the card body (1),
**characterized in that**
- the antenna (3) is embedded completely in the card body (1),
- the antenna (3) is subjected to a signal by means of an electromagnetic field,
- the tool used for material removal is provided with a tap (15) for an electric signal,
- and the execution of material removal is stopped when the contact between the tool used for material removal and the terminals (4) produces a change in the tapped electric signal.

2. The method according to claim 1, **characterized in that** the material removal at the terminals (4) is effected such that a bevel arises.

3. The method according to claim 2, **characterized in that** the angle at which the terminals (4) are cut is preset by the feed direction and the form of the material-removing tool (12).

4. The method according to claim 2, **characterized in that** the angle at which the terminals (4) are cut is preset by the arrangement of the terminals (4) in the card body (1), and the terminals (4) are slanted relative to the surface of the card body (1).

5. The method according to claim 1, **characterized in that** the sensor signal changes as soon as the material-removing tool (12) touches the terminals (4).

6. The method according to claim 1, **characterized in that** the material-removing tool (12) is moved on by a presettable value after touching the terminals (4).

7. The method according to any of the above claims, **characterized in that** the material removal is effected with the aid of a milling tool (12).

8. The method according to any of the above claims, **characterized in that** the exposed terminals (4) are connected with the chip module (2) by means of a conductive adhesive (7).

9. The method according to any of the above claims, **characterized in that** the exposed terminals (4) are connected with the chip module (2) by mechanical contact of electroconductive areas (19) of the chip module (2).

10. The method according to any of the above claims, **characterized in that** the exposed terminals (4) are connected with the chip module (2) by welding.

## Revendications

1. Procédé de fabrication d'un support de données en forme de carte, dans lequel :
- on prépare un module à puce (2) comportant un circuit intégré (10) ainsi que
- un corps de carte (1) muni d'une antenne (3) dont les raccords (4) sont réalisés encastrés dans le corps de carte (1), et dans lequel
- on procède à un enlèvement de matériau du corps de carte (1) pour dégager les raccords (4) encastrés dans le corps de carte (1),
**caractérisé en ce que**
- l'antenne (3) est complètement encastrée dans le corps de carte (1),
- l'antenne (3) est atteinte par un signal au moyen d'un champ électromagnétique,
- l'outil employé pour l'enlèvement de matériau est muni d'un capteur (15) de signal électrique,
- et on stoppe l'exécution de l'enlèvement de matériau lorsqu'un changement du signal électrique capté se produit par contact entre l'outil employé pour l'enlèvement de matériau et les raccords (4).

2. Procédé selon la revendication 1, **caractérisé en ce que** l'enlèvement de matériau est effectué au niveau des raccords (4) de sorte qu'il se forme une entame oblique.

3. Procédé selon la revendication 2, **caractérisé en ce que** l'angle sous lequel les raccords (4) sont entamés est fixé par la direction d'avance et par la forme de l'outil (12) d'enlèvement de matériau.

4. Procédé selon la revendication 2, **caractérisé en ce que** l'angle sous lequel les raccords (4) sont entamés est fixé par l'agencement des raccords (4) dans le corps de carte (1) et **en ce que** les raccords (4) biaisent la surface supérieure du corps de carte (1).

5. Procédé selon la revendication 1, **caractérisé en ce que** le signal de capteur se modifie dès que l'outil (12) d'enlèvement de matériau entre en contact avec les raccords (4).

6. Procédé selon la revendication 1, **caractérisé en ce que** l'outil (12) d'enlèvement de matériau continue encore d'avancer d'une valeur prédéterminée après être entré en contact avec les raccords (4).

7. Procédé selon l'une des revendications précédentes, **caractérisé en ce que** l'enlèvement de matériau est effectué à l'aide d'un outil de fraisage (12).

8. Procédé selon l'une des revendications précédentes, **caractérisé en ce que** les raccords (4) dégagés sont reliés au module à puce (2) au moyen d'une colle conductrice (7).

9. Procédé selon l'une des revendications précédentes, **caractérisé en ce que** les raccords (4) dégagés sont reliés au module à puce (2) par contact mécanique de zones (19) électriquement conductrices du module à puce (2).

10. Procédé selon l'une des revendications précédentes, **caractérisé en ce que** les raccords (4) dégagés sont reliés au module à puce (2) par soudure.
